# EUROPEAN PATENT APPLICATION

(11) **EP 4 845 030 A1**
(43) Date of publication of application: **25.11.2026**
(21) Application number: 26179394.7
(22) Date of filing: 18.05.2026
(51) Int. Cl.: H03G 1/00, H03F 3/45, H03G 3/00, H03G 3/30

(54) **VARIABLE GAIN AMPLIFIER WITH OPEN-LOOP FEEDFORWARD INPUT PATH**

(30) Priority: 22.05.2025 US 202519215993
(71) Applicant: Analog Devices International Unlimited Company, Limerick (IE)
(72) Inventor: BERKOL, Gonenc, Co. Limerick (IE); AKSIN, Devrim Yilmaz, Wilmington, 01887 (US)
(74) Representative: Wallin, Nicholas James

(57) **Abstract**

A variable gain amplifier circuit includes an operational amplifier having inverting and non-inverting input terminals. A first resistor network couples a voltage input and the inverting input terminal and defines a gain characteristic of the circuit. A second resistor network is coupled between a reference signal input and the non-inverting terminal. A feedforward path that includes switchable capacitors shunts portions of the second resistor network. The amplifier can maintain programmable gain for signals at the inverting terminal and unity gain for reference signals at the non-inverting terminal. The capacitive feedforward path enhances small-signal bandwidth tracking of reference signals without affecting amplifier stability.

## Description

### PRIORITY CLAIM

The European patent application claims priority from United States patent application no. 19/215,993, filed 22 May 2025.

### FIELD OF THE DISCLOSURE

This disclosure relates generally to amplifier circuits.

### BACKGROUND

A variable gain amplifier (VGA) is an amplifier that provides variable or adjustable gain to an input signal based on a control signal. Generally, a VGA is configured to maintain good dynamic range across its full gain control range. Other desirable characteristics of a VGA include high linearity, low noise, low DC power consumption, CMOS compatibility, high frequency operation, large signal handling capability, and a gain control that is insensitive to ambient temperature.

Variable Gain Amplifiers (VGAs) are signal-conditioning devices available in analog and digital variants that provide controllable amplification across a wide frequency range, from DC (0 Hz) to gigahertz frequencies. An analog VGA circuit gain can vary with input voltage, while digital VGA circuit gain can depend on binary code inputs. Control signals for these devices can be provided by various sources such as DC sources or digital-to-analog converters (DACs).

Variable gain amplifiers can be used in various systems and devices, including in test systems, sensors, and communications equipment. Example applications that use VGAs to provide gain control include ultrasound, radar, lidar, radio frequency (RF) communications, and/or speech analysis, among others.

### BRIEF SUMMARY

Variable gain amplifier (VGA) circuits can be used in various applications, including in device or signal test and measurement systems. In an example, a VGA includes an amplifier circuit with an inverting input terminal, a non-inverting input terminal, and an output terminal. The circuit can include a first resistor network coupled between a first voltage input and the inverting input terminal, which defines the gain characteristic for the amplifier circuit. A second resistor network connects a second voltage input to the non-inverting input terminal. The VGA can include a feedforward path configured to shunt a portion of the second resistor network. The VGA can provide programmable gain for signals at the inverting terminal and unity gain for reference signals at the non-inverting terminal, thereby allowing accurate tracking of reference variations without affecting the primary amplification function of the circuit.

A method of operating or using a VGA can include configuring an amplifier circuit in response to switch control signals to establish specific operational characteristics of the VGA. The method can include configuring the amplifier circuit to provide a first gain for a drive signal at its inverting terminal while providing unity gain for a reference signal at its non-inverting terminal. A capacitor can selectively shunt at least one resistor in the signal path between a reference input terminal and the non-inverting terminal to provide a feedforward path that enhances bandwidth for reference signal tracking. The amplifier circuit output terminal provides an output voltage signal that is based on both the drive signal and the reference signal.

In an example, the VGA circuits described herein can be used in test environments. For example, a system can include a comparator circuit and a variable-gain amplifier (VGA) circuit that work together to analyze test signals. The comparator circuit receives a test signal from a device under test (DUT) and a voltage threshold signal. The VGA circuit includes an operational amplifier with a first resistor network coupled between a control signal input and the inverting input terminal, which establishes a closed-loop gain. A second resistor network connects a reference signal input to the non-inverting input terminal. The system includes a feedforward path that shunts a portion of the second resistor network between the reference input and non-inverting terminal. This architecture allows the system to track reference signal variations with unity gain while maintaining programmable gain for the control signal, thereby enabling accurate threshold generation for test signal analysis with enhanced bandwidth capability.

This Summary is intended to provide an overview of subject matter related to variable gain amplifiers and related systems and methods. It is not intended to provide an exclusive or exhaustive explanation. The detailed description is included to provide further information.

### BRIEF DESCRIPTION OF THE SEVERAL VIEWS OF THE DRAWINGS

In the drawings, which are not necessarily drawn to scale, like numerals may describe similar components in different views. Like numerals may represent different instances of similar components. The drawings illustrate generally, by way of example, but not by way of limitation, various embodiments discussed in the present document.
FIG. 1 illustrates generally an example of a portion of a time management unit (TMU).
FIG. 2 illustrates generally a first timing diagram showing a timing relationship between test signal transitions and corresponding comparator circuit output transitions.
FIG. 3 illustrates generally a second timing diagram showing an effect of a variable reference node on a test signal.
FIG. 4 illustrates generally an example of a first variable gain amplifier circuit.
FIG. 5 illustrates generally an example of a second variable gain amplifier circuit with a feedforward path.
FIG. 6 illustrates generally an example of a method for operating a variable gain amplifier circuit with a feedforward signal path.

### DETAILED DESCRIPTION

Variable gain amplifier (VGA) architectures are discussed herein. In an example, a VGA circuit can be configured to use two distinct signal paths and a single amplifier circuit. Respective matched resistor networks at the amplifier circuit inputs can be used to provide programmable gain for a first path (e.g., a primary input signal path) and unity gain for a second path (e.g., a secondary input signal path, such as can be used for reference signal tracking). The circuits discussed herein can include or use a capacitive feedforward path to increase reference signal tracking bandwidth without compromising amplifier stability.

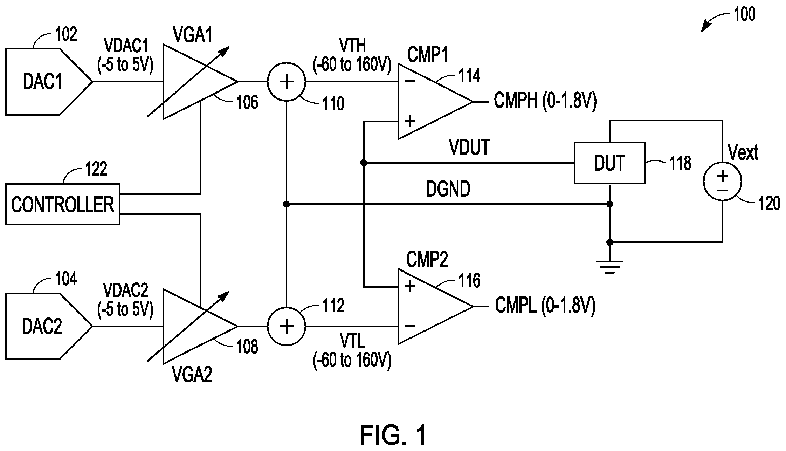

FIG. 1 illustrates generally an example of a time management unit (TMU) or TMU system 100. In some examples, the TMU system 100 can comprise a portion of a test system or automated test equipment (ATE) system. The example of the TMU system 100 includes a first digital-to-analog converter (DAC) circuit or first DAC 102, a second DAC 104, a first variable gain amplifier (VGA) circuit or first VGA 106, a second VGA 108, a first summing node 110, a second summing node 112, a first comparator circuit 114, a second comparator circuit 116, a device under test (DUT) or DUT 118, a controller 122, and a voltage source 120. In an example, the TMU system 100 measures rise and fall times of signals from the DUT 118 in response to an external excitation voltage Vext from the voltage source 120.

The DUT 118 receives the external excitation voltage Vext from the voltage source 120, which can drive high voltage signals (e.g., up to 220V) to the DUT 118. In response, the DUT 118 provides an output signal VDUT that transitions between voltage levels. In the example of FIG. 1, the DUT 118 is coupled to a reference node DGND. The reference node of the DUT can experience fast transient variations. In some examples, transients on DGND can exceed several megahertz. In an example, the VGA circuits can be configured to track DGND variations while maintaining their programmed gain settings to help maintain specified threshold levels for the comparator circuits.

The example of FIG. 1 shows the VGA circuits driven by the outputs of respective DAC circuits. Other signal sources can similarly be used to drive the VGA circuits. In the example of FIG. 1, in response to digital DAC control signals, the first DAC 102 and second DAC 104 can provide respective analog low-voltage control signals VDAC1 and VDAC2 (e.g., each ranging from about -5V to 5V) to the first VGA 106 and the second VGA 108. The controller 122 or another source can provide the digital DAC control signals. The first VGA 106 and second VGA 108 can amplify the received low-voltage inputs from the DAC circuits to generate reference threshold voltages VTH and VTL, respectively. In an example, the reference threshold voltages range from about -60V to about 160V.

The TMU system 100 can include, or can be coupled to, the controller 122. In an example, the controller 122 is configured to provide respective control signals to the first VGA 106 and the second VGA 108. The control signals can indicate a specified gain or other characteristic to be implemented by the VGA circuits.

In an example, the first summing node 110 and second summing node 112 combine the respective VGA circuit outputs with the DUT ground (DGND) signal to provide the reference threshold voltages VTH and VTL. The first comparator circuit 114 and second comparator circuit 116 compare the DUT output signal VDUT against these threshold voltages and, in response, provide respective comparator output signals CMPH and CMPL. In an example, each of the first comparator circuit 114 and the second comparator circuit 116 comprises a self-protected input stage (e.g., up to 220V) and is configured to provide its output as a digital signal (e.g., 0-1.8V).

In an example, the first VGA 106 and the second VGA 108 are configured to operate at near-DC conditions to generate DC threshold signals for the first comparator circuit 114 and the second comparator circuit 116, respectively. In some TMU architectures, a VGA can be configured to sense the DUT ground (DGND) and adjust its output accordingly. In an example, the VGA outputs VTH and VTL can be configured to track DGND with unity gain while maintaining programmable gain for each DAC input code.

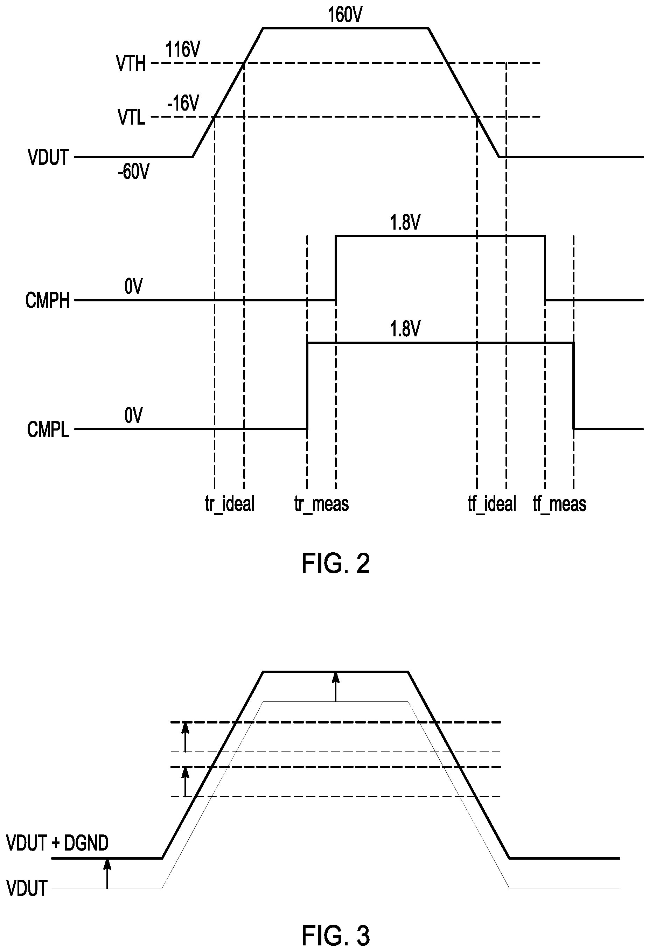

FIG. 2 illustrates generally a first timing diagram 200 showing a timing relationship between DUT signal transitions and corresponding comparator circuit output transitions from the TMU system 100. The VTH and VTL threshold voltages define the measurement levels (e.g., 20%-80% of full scale) for detecting signal transitions. The CMPH and CMPL outputs from the first comparator circuit 114 and the second comparator circuit 116, respectively, transition between 0V and 1.8V when VDUT crosses the thresholds. In an example, the time differences between the comparator output edges (tr_meas, tf_meas) represent the measured rise/fall times compared to ideal transitions (tr_ideal, tf_ideal).

The time offset between ideal and measured rise/fall times shown in FIG. 2 is a function of a signal propagation delay through the measurement system components. This offset occurs due to several factors in the signal chain. For example, the measured times (tr_meas, tf_meas) differ from ideal times (tr_ideal, tf_ideal) due to propagation delays through the comparator circuits, response times of the VGAs tracking DGND variations, physical limitations in how quickly the comparators can switch states when input thresholds are crossed, and signal path characteristics between the DUT 118 and the inputs of the first comparator circuit 114 and the second comparator circuit 116, among others.

FIG. 3 illustrates generally a second timing diagram 300. The second timing diagram 300 shows two waveforms that demonstrate how the DUT ground or reference (DGND) can influence voltage measurements from the DUT 118.

The upper waveform (labeled VDUT + DGND) represents a combined voltage signal that includes both the actual DUT output signal and the ground reference variation. This combined signal shows that an apparent DUT output voltage can change when measured relative to a shifting ground reference. The lower waveform (labeled VDUT) represents the same DUT output signal referenced to a fixed system ground rather than a variable reference. The vertical displacement between these two waveforms represents the magnitude of the ground variation (DGND) at any given point in time. When DGND shifts, the entire VDUT + DGND waveform shifts relative to the VDUT reference waveform.

The example of FIG. 3 helps show why it can be important for the first VGA 106 and the second VGA 108 of the TMU system 100 to track DGND. Without tracking ground variations, the comparison thresholds VTH and VTL would be referenced to a fixed ground rather than the actual DUT ground, resulting in measurement errors when determining signal rise and fall times. The VGA architecture discussed herein helps address this challenge by maintaining unity gain for DGND tracking while still allowing programmable gain for the DAC inputs.

The present inventor has thus recognized that a problem to be solved includes implementing variable gain amplifiers (VGAs) that can provide programmable gain settings (e.g., for amplifying DAC output signals) while tracking reference or ground (e.g., DUT ground or DGND) variations with unity gain. The present subject matter can help provide a solution to this problem, for example, by using a single high-voltage amplifier with a resistor array architecture that enables programmable gain from a DAC input while maintaining unity gain for reference or DGND tracking.

In an example, the solution can include or use an open-loop feedforward path to address bandwidth limitations. For example, while the DAC operates at slow speed or DC, the reference node can experience fast transients (e.g., up to or exceeding several megahertz). The feedforward path allows enhanced bandwidth tracking of the reference node without requiring expensive high-bandwidth amplifiers. In an example, the solution can include providing the capacitive feedforward path on a non-inverting terminal of the amplifier, which enables bandwidth enhancement without compromising amplifier stability. The solutions discussed herein can help enable a VGA to efficiently track fast reference node (e.g., DGND) variations while maintaining programmable gain functionality with low power consumption.

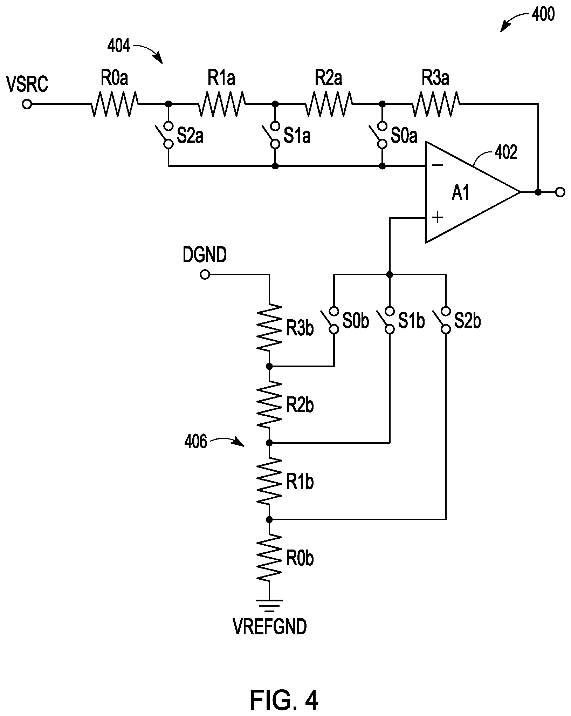

FIG. 4 illustrates generally an example of a first VGA circuit 400. The first VGA circuit 400 includes an amplifier circuit 402 with inverting and non-inverting input terminals. The inverting terminal is configured to receive a source signal VSRC through a first resistor network 404, and the non-inverting terminal is configured to receive a reference signal DGND through a second resistor network 406.

The first resistor network 404 includes resistors R0a, R1a, R2a, and R3a, provided in series between a primary input node that receives the source signal VSRC and the inverting input terminal of the amplifier circuit 402. The first resistor network 404 includes switches S0a, S1a, and S2a positioned between respective junctions of the resistors. Each of the switches includes a terminal that is coupled to the inverting input terminal of the amplifier circuit 402. That is, switch S0a is coupled between the inverting input terminal and the junction of resistors R0a and R1a, switch S1a is coupled between the inverting input terminal and the junction of resistors R1a and R2a, and switch S2a is coupled between the inverting input terminal and the junction of resistors R2a and R3a. The switches are configured to selectively provide different resistance values in the signal path from the primary input node to the inverting input terminal of the amplifier circuit 402, thereby enabling programmable gain settings for the amplifier circuit 402.

The second resistor network 406 includes resistors R0b, R1b, R2b, and R3b, provided in series between a secondary input node and a VGA reference node (VREFGND). In an example, the secondary input node is coupled to the DUT 118 and is configured to receive the DUT reference DGND, and the secondary input node is coupled to a first terminal of resistor R3b. The second resistor network 406 is coupled to the non-inverting input terminal of the amplifier circuit 402 using multiple switches S0b, S1b, and S2b positioned between respective junction points of the resistors. For example, switch S0b is coupled to the junction of resistors R3b and R2b, switch S1b is coupled to the junction of resistors R2b and R1b, and switch S2b is coupled to the junction of resistors R1b and R0b. In the example of FIG. 4, the second resistor network 406 is connected to VREFGND through resistor R0b.

The illustrated examples of the first resistor network 404 and the second resistor network 406 each include four resistors and three switches. Each switch can represent or correspond to a different gain setting available for the first VGA circuit 400. Additional or fewer resistors can similarly be used to scale the number of gain settings available for the first VGA circuit 400.

The resistors in the first resistor network 404 and the second resistor network 406 are matched replica devices having same-valued resistance characteristics. That is, resistance values of R0a and R0b can be the same, resistance values of R1a and R1b can be the same, and so on. In some examples, each of the resistors has a same-valued resistance characteristic. In this case, the resistance of each resistor R0x is the same as the resistance of each resistor R1x, R2x, and R3x. Other resistance values can be used, however, the matched resistance values helps enable unity gain for signals received from the secondary input node.

The example of the first VGA circuit 400 has three programmable gain settings, G0, G1, and G2. Each gain setting corresponds to a particular configuration of the switches. For example, the first gain setting G0 corresponds to the first switches S0a and S0b being on or closed, while the other switches S1a, S1b, S2a, and S2b are off or open. In this configuration, the inverting gain of the first gain setting G0 can be expressed as - R3a/(R0a+R1a+R2a) for signals received at the primary input node.

For each gain setting of the first VGA circuit 400, the gain from the secondary input node to the output of the amplifier circuit 402 is 1 or unity gain. For example, when the first switches S0a and S0b are on, the other switches S1a, S1b, S2a, and S2b are off. In this configuration, the signal at the secondary input node (e.g., DGND) is scaled by a factor of (R0b+R1b+R2b)/(R0b+R1b+R2b+R3b) and then amplified by the non-inverting gain of the amplifier circuit 402 which can be expressed as 1 + R3a/(R0a+R1a+R2a). The product of the scaled signal and the non-inverting gain is 1 or unity gain. As a result, the gain from the secondary input node (e.g., DGND) to the output of the first VGA circuit 400 can be made to be equal to one regardless of the programmable gain value used in the inverting path and received from the primary input node (e.g., VSRC). The matching resistor values and their reversed arrangement between the first and second resistor networks creates a relationship where the product of the signal scaling and the non-inverting gain precisely equals unity, regardless of which gain setting is selected.

The first VGA circuit 400 thus operates by providing programmable gain from the source signal VSRC to the VGA output while maintaining unity gain from the reference signal DGND to the output. When a specific switch (e.g., S0a) in the first resistor network 404 is activated, the corresponding switch (e.g., S0b) in the second resistor network 406 is activated to maintain the resistor-matching relationship. For each gain setting, the transfer function from DGND to the output equals unity (gain = 1), regardless of the selected gain value for VSRC. The first VGA circuit 400 can thus track a reference ground signal (e.g., a DUT ground or reference signal DGND) with unity gain while amplifying the source signal VSRC with a programmable gain factor. The gain from VSRC is determined by the ratio of resistors in the feedback path to the resistors in the input path, following inverting amplifier configuration principles.

In an example, bandwidth characteristics of the first VGA circuit 400 can be improved by providing a feedforward path from the secondary input node to the non-inverting input terminal of the amplifier. The bandwidth of this feedforward path can be made substantially larger than a bandwidth of the inverting input terminal signal path without affecting a stability of the amplifier in the VGA circuit.

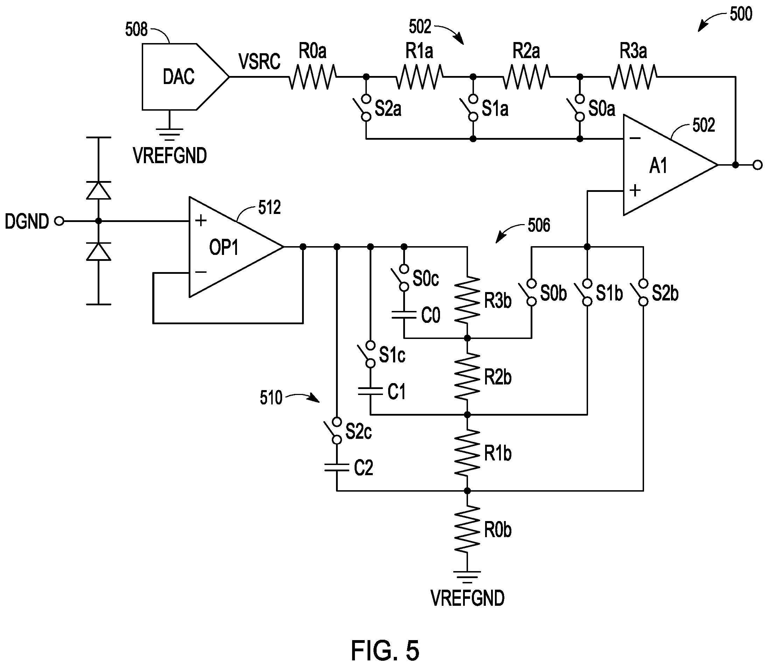

FIG. 5 illustrates generally an example of a second VGA circuit 500 with a feedforward path. The second VGA circuit 500 includes an amplifier circuit 502 with inverting and non-inverting input terminals. In an example, the amplifier circuit 502 is an operational amplifier circuit. The inverting terminal is configured to receive a source signal VSRC through a first resistor network 504, and the non-inverting terminal is configured to receive a reference signal DGND through a second resistor network 506. In an example, the first resistor network 504 is configured similarly to the first resistor network 404 from the example of FIG. 4, and the second resistor network 506 is configured similarly to the second resistor network 406 from the example of FIG. 4. Resistors and switches that comprise the second VGA circuit 500 and the first VGA circuit 400 can be similarly valued and configured for operation in a similar or same manner.

In the inverting input signal path, the second VGA circuit 500 includes a DAC circuit 508 configured to provide the input signal VSRC. In an example, the DAC circuit 508 comprises an example of the first DAC 102 or the second DAC 104 from the TMU system 100. Other signal sources can similarly be used.

In the non-inverting input signal path, the second VGA circuit 500 includes a buffer circuit 512 that is configured to receive the reference signal DGND. The buffer circuit 512 includes, for example, an operational amplifier (OP1) configured to prevent loading of the DGND signal source. In some examples where the reference source provides current, the buffer circuit 512 can be omitted.

The second VGA circuit 500 includes all elements of the first VGA circuit 400 but adds a feedforward circuit 510. The feedforward circuit 510 includes capacitors C0, C1, and C2 switchably arranged in parallel with portions of the second resistor network 506. For example, a first capacitor C0 is configured to shunt resistor R3b, a second capacitor C1 is configured to shunt a series combination of resistors R2b and R3b, and a third capacitor C3 is configured to shunt a series combination of resistors R1b, R2b, and R3b. Each of the capacitors C0, C1, and C2 can be separately switched into the feedforward circuit 510 using a respective feedforward enable switch. That is, the first capacitor C0 shunts resistor R3b when a first switch S0c is closed, the second capacitor C1 shunts the series combination of resistors R2b and R3b and a second switch S1c is closed, and so on. The switches for the feedforward circuit 510 are configured to operate in coordination with the switches for the first resistor network 504 and the second resistor network 506. In other words, the first switches S0a, S0b, and S0c are closed together while the other switches remain open to realize a first gain configuration for the second VGA circuit 500, the second switches S1a, S1b, and S2c are closed together while the other switches remain open to realize a second gain configuration for the second VGA circuit 500, and so on. While the example of the second VGA circuit 500 shows three different gain configuration, additional or fewer gain configurations can similarly be used. The feedforward path enables enhanced small-signal bandwidth when tracking the reference signal DGND for each of the gain configurations.

The feedforward path operates when enabled through a particular one of the switches S0c, S1c, and S2c. When a switch is closed, the corresponding capacitor creates a low-impedance path at higher frequencies. This allows high-frequency components of the DGND signal to bypass the resistor network and reach the non-inverting input terminal of the amplifier circuit 502 directly. In the example of FIG. 5, the feedforward elements are placed in the non-inverting signal path, rather than in the feedback loop. This capacitive feedforward path thus helps increase the small-signal bandwidth for the unity gain path (e.g., from DGND) to the output of the second VGA circuit 500 without affecting stability of the amplifier circuit 502.

In some examples, the second VGA circuit 500 includes or uses a programmable bias current controller configured to adjust the operating current of the amplifier circuit 502. The programmable bias current can be used to configure the amplifier circuit 502 to accommodate different applications. For example, when higher slew rate or increased load driving capability is needed, the bias current can be increased. Conversely, the bias current can be reduced to conserve power. The programmable bias current can operate independently from the gain settings and feedforward path.

The second VGA circuit 500 enables efficient tracking of fast reference signal (e.g., DGND) variations while maintaining programmable gain and stable operation across different gain settings. Furthermore, the solution is lower-power compared to other high-bandwidth amplifier implementations. The resistor networks and switch configurations allow programmable gain from the inverting terminal while maintaining unity gain from the non-inverting terminal through a single high-voltage amplifier (e.g., the amplifier circuit 502) with matched resistor arrays (e.g., the first resistor network 504 and the second resistor network 506). This architecture can be expanded or reduced to implement different numbers of gain settings by modifying the corresponding switches and resistor arrays. The open-loop feedforward path through capacitors C0, C1, and C2 increases the small-signal bandwidth for tracking reference variations without affecting amplifier stability. By placing the feedforward elements in the non-inverting signal path rather than the feedback loop, the architecture achieves enhanced bandwidth tracking while maintaining stable operation.

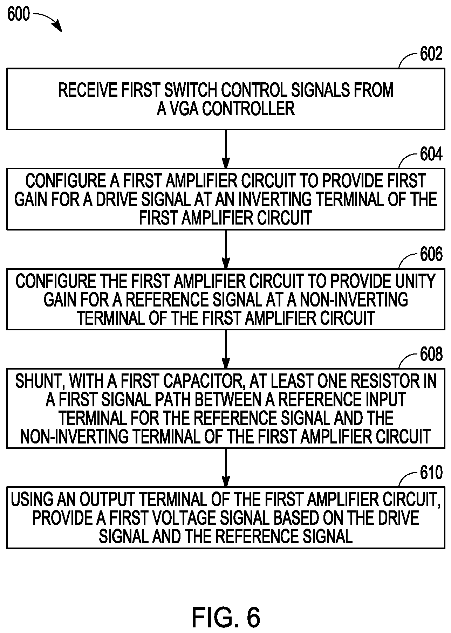

FIG. 6 illustrates an example of a method 600 for operating a variable gain amplifier (VGA) circuit with an open-loop feedforward input path. Although the example of the method 600 depicts a particular sequence of operations, the sequence may be altered without departing from the scope of the present disclosure. For example, some of the operations depicted may be performed in parallel or in a different sequence that does not materially affect the function of the method 600. In other examples, different components of an example device or system that implements the method 600 may perform functions at substantially the same time or in a specific sequence.

At operation 602, the method 600 includes receiving first switch control signals from a VGA controller. The controller can provide signals (e.g., digital signals) that determine which switches in the resistor networks (e.g., the first resistor network 404 and the second resistor network 406 of the first VGA circuit 400, or the first resistor network 504 and the second resistor network 506 of the second VGA circuit 500, etc.) will be closed or opened to establish a specific gain configuration for the VGA circuit. The control signals select which resistors will be active in both the inverting terminal path and the non-inverting terminal path. The switch control signals can originate from a controller component such as the controller 122 shown in FIG. 1, which manages the TMU system configuration based on measurement requirements.

At operation 604, the method 600 includes configuring a first amplifier circuit of the VGA to provide first gain for a drive signal at an inverting terminal of the first amplifier circuit. Operation 604 can include activating specific switches in a first resistor network (e.g., the first resistor network 404 or the first resistor network 504) coupled between the drive signal input and the inverting terminal of the first amplifier circuit, and configured to provide a feedback path between the output terminal and the inverting terminal. For example, when a first switch (e.g., S0a) is activated while other switches remain open, the amplifier circuit provides a first gain value (e.g., G0) determined by the ratio of feedback resistance to input resistance.

At operation 606, the method 600 includes configuring the first amplifier circuit to provide unity gain for a reference signal at a non-inverting terminal of the first amplifier circuit. In an example, operation 606 occurs concurrently with operation 604 and includes activating one or more switches in a second resistor network (e.g., the second resistor network 406 or the second resistor network 506) connected to the non-inverting terminal of the first amplifier circuit. The second resistor network includes resistors arranged in reverse order compared to the first resistor network, allowing the amplifier to maintain unity gain from the reference signal input (such as DGND) to the output regardless of the gain setting for the drive signal. When the same switch pattern is activated in both networks, the transfer function from the reference signal to the output equals one.

At operation 608, the method 600 includes establishing a feedforward path for the VGA circuit. Operation 608 can include shunting, with a first capacitor, at least one resistor in a signal path between a reference input terminal for the reference signal and the non-inverting terminal of the first amplifier circuit. This provides a capacitive feedforward path that enhances the small-signal bandwidth for tracking the reference signal. For example, the capacitor provides a low-impedance path at higher frequencies, allowing high-frequency components of the reference signal to bypass portions of the second resistor network. This helps increase bandwidth without affecting amplifier stability since the feedforward elements are placed in the non-inverting signal path rather than the feedback loop.

At operation 610, the method 600 includes using an output terminal of the first amplifier circuit to provide a first voltage signal based on the drive signal and the reference signal. The output signal combines the amplified drive signal with the unity-gain reference signal tracking. In applications such as a TMU system, this output signal serves as a threshold voltage (e.g., VTH or VTL) for comparator circuits that measure signal transitions from a device under test. The voltage signal maintains accurate threshold levels by tracking reference variations while applying programmable gain to the drive signal input.

The example of the method 600 can optionally include other operations. For example, the method 600 can include receiving second switch control signals from the VGA controller to configure the amplifier for a different gain setting. These control signals activate an alternative switch pattern (e.g., S1a, S1b, S1c instead of S0a, S0b, S0c) to establish a different gain configuration for the VGA circuit.

In an example, the method 600 can include shunting different resistor combinations with additional capacitors. For each gain configuration, a corresponding capacitor in the feedforward path can be selectively switched in to bypass specific portions of the resistor network. For instance, a second capacitor can shunt at least two resistors in series (e.g., R2b and R3b), while a third capacitor can shunt three resistors in series (e.g., R1b, R2b, and R3b), and so on. Each capacitor-resistor configuration provides a frequency-dependent impedance path that enhances bandwidth tracking for specific gain settings without affecting amplifier stability.

In an example, the method 600 includes receiving input signals from various sources such as DACs or DUTs. The drive signal at the inverting terminal can be received from, for example, a DAC that is configured to provide programmable voltage levels, while the reference signal at the non-inverting terminal can be received from a DUT ground or DUT reference. In some examples, a buffer circuit can receive and condition the reference signal before it reaches the amplifier circuit input.

In an example, the method 600 includes using the output voltage signal in comparison operations to generate timing information about a DUT. After the VGA produces an output voltage with specified gain and bandwidth characteristics, this output signal can serve as a comparison threshold for a comparator circuit. The comparator circuit can compare the DUT output signal against this threshold to identify timing information about features of the DUT output signal. Signal feature timing characteristics can be used to characterize operation of a DUT.

Various aspects of the present disclosure can help provide a solution to the variable gain amplifier (VGA) circuit limitations and problems identified herein, as set forth in the following Examples.

Example 1 is an apparatus comprising: an amplifier circuit comprising an inverting input terminal, a non-inverting input terminal, and an output terminal; a first resistor network coupled between a first voltage input and the inverting input terminal of the amplifier circuit, wherein the first resistor network defines a first gain characteristic for the amplifier circuit; a second resistor network coupled between a second voltage input and the non-inverting input terminal of the amplifier circuit; and a feedforward path configured to shunt a portion of the second resistor network, wherein the feedforward path is coupled between the second voltage input and the non-inverting input terminal of the amplifier circuit.

In Example 2, the subject matter of Example 1 optionally includes the feedforward path comprises a capacitor switchably coupled in parallel with one or more resistors of the second resistor network.

In Example 3, the subject matter of Example 2 optionally includes the first resistor network comprises at least two resistors coupled in series, and the second resistor network is a replica of the first resistor network and comprises at least two other resistors coupled in series.

In Example 4, the subject matter of Example 3 optionally includes a first switch network configured to provide an adjustable-impedance feedback signal path between the output terminal and the inverting terminal of the amplifier circuit, wherein the feedback signal path includes at least one of the resistors of the first resistor network; and a second switch network configured to provide an adjustable-impedance reference signal path between the second voltage input and the non-inverting input terminal of the amplifier circuit, wherein the reference signal path includes at least one of the resistors of the second resistor network, and wherein one or more other resistors of the second resistor network are coupled to a reference terminal.

In Example 5, the subject matter of Example 4 optionally includes a controller for the first and second switch networks, wherein the controller is configured to provide respective switch command signals to one or more switches in each of the first and second switch networks to adjust the first gain characteristic of the amplifier circuit.

In Example 6, the subject matter of Example 5 optionally includes the second switch network includes a feedforward enable switch configured to selectively couple the capacitor in the feedforward path.

In Example 7, the subject matter of any one or more of Examples 4-6 optionally includes a resistance characteristic of the feedback path is substantially the same as a resistance characteristic of the reference signal path.

In Example 8, the subject matter of Example 7 optionally includes the second resistor network and the amplifier circuit are configured to provide unity gain between the second voltage input and the output terminal of the amplifier circuit.

In Example 9, the subject matter of any one or more of Examples 4-8 optionally includes a digital-to-analog converter (DAC) circuit configured to provide a first input signal at the first voltage input, wherein the DAC circuit is configured to provide the first input signal referenced to the reference terminal.

In Example 10, the subject matter of any one or more of Examples 1-9 optionally includes the second voltage input is configured to receive a reference voltage signal from a device under test (DUT).

In Example 11, the subject matter of Example 10 optionally includes a comparator circuit coupled to the output terminal of the amplifier circuit and to the DUT, wherein the comparator circuit is configured to provide information about a relationship between an output signal from the DUT and a voltage threshold signal from the output terminal of the amplifier circuit.

In Example 12, the subject matter of any one or more of Examples 1-11 optionally includes a voltage buffer circuit configured to receive a reference voltage signal from a device under test (DUT) and, in response, provide a buffered signal at the second voltage input.

Example 13 is a method comprising: in response to first switch control signals: configuring a first amplifier circuit to provide first gain for a drive signal at an inverting terminal of the first amplifier circuit, configuring the first amplifier circuit to provide unity gain for a reference signal at a non-inverting terminal of the first amplifier circuit, and shunting, with a first capacitor, at least one resistor in a first signal path between a reference input terminal for the reference signal and the non-inverting terminal of the first amplifier circuit; and using an output terminal of the first amplifier circuit, providing a first voltage signal based on the drive signal and the reference signal.

In Example 14, the subject matter of Example 13 optionally includes in response to second switch control signals: configuring the first amplifier circuit to provide second gain for the drive signal at the inverting terminal of the first amplifier circuit, configuring the first amplifier circuit to provide unity gain for the reference signal at the non-inverting terminal of the first amplifier circuit, and shunting, with a second capacitor, at least two resistors in a second signal path between the reference input terminal for the reference signal and the non-inverting terminal of the first amplifier circuit; wherein the second gain for the drive signal is greater than the first gain, and wherein a bandwidth characteristic at the non-inverting terminal is greater than a bandwidth characteristic at the inverting terminal.

In Example 15, the subject matter of any one or more of Examples 13-14 optionally includes configuring the first amplifier circuit to provide first gain for the drive signal includes: coupling at least a first resistor between the output terminal and the inverting input terminal of the first amplifier circuit, and coupling at least a second resistor between the inverting input terminal of the first amplifier circuit and a first voltage input configured to receive the drive signal, and coupling at least a third resistor between the non-inverting terminal of the first amplifier circuit and the reference input terminal, wherein the first and third resistors have the same resistance characteristic.

In Example 16, the subject matter of any one or more of Examples 13-15 optionally includes receiving the drive signal, via a first resistive path, from a digital-to-analog converter (DAC) circuit; receiving the reference signal from a device under test (DUT), and using a comparator circuit, comparing the first voltage signal with an output signal from the DUT to provide timing information about the DUT.

In Example 17, the subject matter of any one or more of Examples 13-16 optionally includes receiving, at a buffer circuit and from a device under test (DUT), a DUT output signal, and using the buffer circuit, providing the reference signal to the reference input terminal in response to receiving the DUT output signal.

Example 18 is a system comprising: a first comparator circuit configured to receive a test signal from a device under test (DUT) at a first comparator input terminal and a first voltage threshold signal at a second comparator input terminal; and a first variable-gain amplifier (VGA) circuit configured to receive a first control signal and, in response, provide the first voltage threshold signal to the first comparator circuit, wherein the first VGA circuit comprises: an operational amplifier (op-amp) circuit comprising an inverting input terminal, a non-inverting input terminal, and an output terminal; a first resistor network coupled between a first voltage input and the inverting input terminal of the op-amp circuit, wherein the first resistor network defines a closed-loop gain characteristic of the op-amp circuit, and wherein the first voltage input is configured to receive the first control signal; a second resistor network coupled between a second voltage input and the non-inverting input terminal of the op-amp circuit; and a feedforward path configured to shunt a portion of the second resistor network, wherein the feedforward path is coupled between the second voltage input and the non-inverting input terminal of the op-amp circuit.

In Example 19, the subject matter of Example 18 optionally includes the feedforward path comprises a capacitor and a switch configured to selectively couple the capacitor in parallel with one or more resistors of the second resistor network.

In Example 20, the subject matter of Example 19 optionally includes a feedback path that includes one or more resistors of the first resistor network coupled in series between the output and inverting input terminals of the op-amp circuit. In Example 19, a resistance of the feedback path can be substantially the same as a resistance of the one or more resistors of the second resistor network provided in parallel with the capacitor.

Example 21 is at least one machine-readable medium including instructions that, when executed by processing circuitry, cause the processing circuitry to perform operations to implement control systems or methods corresponding to any of Examples 1-20.

Example 22 is an apparatus comprising means to implement of any of Examples 1-20.

Each of the non-limiting aspects or examples described herein may stand on its own, or may be combined in various permutations or combinations with one or more of the other examples discussed herein.

The above detailed description includes references to the accompanying drawings, which form a part of the detailed description. The drawings show, by way of illustration, specific embodiments in which the invention may be practiced. These embodiments are also referred to herein as "aspects" or "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of"at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

## Claims

1. An apparatus comprising:
an amplifier circuit comprising an inverting input terminal, a non-inverting input terminal, and an output terminal;
a first resistor network coupled between a first voltage input and the inverting input terminal of the amplifier circuit, wherein the first resistor network defines a first gain characteristic for the amplifier circuit;
a second resistor network coupled between a second voltage input and the non-inverting input terminal of the amplifier circuit; and
a feedforward path configured to shunt a portion of the second resistor network, wherein the feedforward path is coupled between the second voltage input and the non-inverting input terminal of the amplifier circuit.

2. The apparatus of claim 1, wherein the feedforward path comprises a capacitor switchably coupled in parallel with one or more resistors of the second resistor network.

3. The apparatus of claim 2, wherein the first resistor network comprises at least two resistors coupled in series, and wherein the second resistor network is a replica of the first resistor network and comprises at least two other resistors coupled in series.

4. The apparatus of claim 3, comprising:
a first switch network configured to provide an adjustable-impedance feedback signal path between the output terminal and the inverting terminal of the amplifier circuit, wherein the feedback signal path includes at least one of the resistors of the first resistor network; and
a second switch network configured to provide an adjustable-impedance reference signal path between the second voltage input and the non-inverting input terminal of the amplifier circuit, wherein the reference signal path includes at least one of the resistors of the second resistor network, and wherein one or more other resistors of the second resistor network are coupled to a reference terminal.

5. The apparatus of claim 4, comprising a controller for the first and second switch networks, wherein the controller is configured to provide respective switch command signals to one or more switches in each of the first and second switch networks to adjust the first gain characteristic of the amplifier circuit; wherein optionally the second switch network includes a feedforward enable switch configured to selectively couple the capacitor in the feedforward path.

6. The apparatus of claim 4 or 5, wherein a resistance characteristic of the feedback path is substantially equal to a resistance characteristic of the reference signal path; wherein optionally the second resistor network and the amplifier circuit are configured to provide unity gain between the second voltage input and the output terminal of the amplifier circuit.

7. The apparatus of any of claims 4 to 6, comprising a digital-to-analog converter (DAC) circuit configured to provide a first input signal at the first voltage input, wherein the DAC circuit is configured to provide the first input signal referenced to the reference terminal.

8. The apparatus of any of claims 1 to 7, wherein the second voltage input is configured to receive a reference voltage signal from a device under test (DUT), the apparatus optionally further comprising a comparator circuit coupled to the output terminal of the amplifier circuit and to the DUT, wherein the comparator circuit is configured to provide information about a relationship between an output signal from the DUT and a voltage threshold signal from the output terminal of the amplifier circuit.

9. The apparatus of any of claims 1 to 8, comprising a voltage buffer circuit configured to receive a reference voltage signal from a device under test (DUT) and, in response, provide a buffered signal at the second voltage input.

10. A method comprising:
in response to first switch control signals:
configuring a first amplifier circuit to provide first gain for a drive signal at an inverting terminal of the first amplifier circuit,
configuring the first amplifier circuit to provide unity gain for a reference signal at a non-inverting terminal of the first amplifier circuit, and
shunting, with a first capacitor, at least one resistor in a first signal path between a reference input terminal for the reference signal and the non-inverting terminal of the first amplifier circuit; and
using an output terminal of the first amplifier circuit, providing a first voltage signal based on the drive signal and the reference signal.

11. The method of claim 10, comprising, in response to second switch control signals:
configuring the first amplifier circuit to provide second gain for the drive signal at the inverting terminal of the first amplifier circuit,
configuring the first amplifier circuit to provide unity gain for the reference signal at the non-inverting terminal of the first amplifier circuit, and
shunting, with a second capacitor, at least two resistors in a second signal path between the reference input terminal for the reference signal and the non-inverting terminal of the first amplifier circuit;
wherein the second gain for the drive signal is greater than the first gain, and wherein a bandwidth characteristic at the non-inverting terminal is greater than a bandwidth characteristic at the inverting terminal.

12. The method of claims 10 or 11, wherein configuring the first amplifier circuit to provide first gain for the drive signal includes:
coupling at least a first resistor between the output terminal and the inverting input terminal of the first amplifier circuit, and
coupling at least a second resistor between the inverting input terminal of the first amplifier circuit and a first voltage input configured to receive the drive signal, and
coupling at least a third resistor between the non-inverting terminal of the first amplifier circuit and the reference input terminal, wherein the first and third resistors have a same resistance characteristic.

13. The method of any of claims 10 to 12, comprising one or both of:
a) receiving the drive signal, via a first resistive path, from a digital-to-analog converter (DAC) circuit; receiving the reference signal from a device under test (DUT); and using a comparator circuit, comparing the first voltage signal with an output signal from the DUT to provide timing information about the DUT; and/or
b) receiving, at a buffer circuit and from a device under test (DUT), a DUT output signal; and using the buffer circuit, providing the reference signal to the reference input terminal in response to receiving the DUT output signal.

14. A system comprising:
a first comparator circuit configured to receive a test signal from a device under test (DUT) at a first comparator input terminal and a first voltage threshold signal at a second comparator input terminal; and
a first variable-gain amplifier (VGA) circuit configured to receive a first control signal and, in response, provide the first voltage threshold signal to the first comparator circuit, wherein the first VGA circuit comprises:
an operational amplifier (op-amp) circuit comprising an inverting input terminal, a non-inverting input terminal, and an output terminal;
a first resistor network coupled between a first voltage input and the inverting input terminal of the op-amp circuit, wherein the first resistor network defines a closed-loop gain characteristic of the op-amp circuit, and wherein the first voltage input is configured to receive the first control signal;
a second resistor network coupled between a second voltage input and the non-inverting input terminal of the op-amp circuit; and
a feedforward path configured to shunt a portion of the second resistor network, wherein the feedforward path is coupled between the second voltage input and the non-inverting input terminal of the op-amp circuit.

15. The system of claim 14, wherein the feedforward path comprises a capacitor and a switch configured to selectively couple the capacitor in parallel with one or more resistors of the second resistor network; the system optionally further comprising a feedback path that includes one or more resistors of the first resistor network coupled in series between the output and inverting input terminals of the op-amp circuit, wherein a resistance of the feedback path is substantially equal to a resistance of the one or more resistors of the second resistor network provided in parallel with the capacitor.
